Europäisches Patentamt

European Patent Office

Office européen des brevets

(11) Numéro de publication: **0 197 838 B1**

(12) **FASCICULE DE BREVET EUROPEEN**

(45) Date de publication du fascicule du brevet:
23.11.89

(21) Numéro de dépôt: 86400634.1

(22) Date de dépôt: **25.03.86**

(51) Int. Cl.⁴: **H01L 21/28,** H01L 29/80, H01L 29/60, H01L 29/62, H01L 21/00

(54) Procédé de réalisation d'un transistor à effet de champ à métallisation de grille autoalignée.

(30) Priorité: **01.04.85 FR 8504491**

(43) Date de publication de la demande:
**15.10.86 Bulletin 86/42**

(45) Mention de la délivrance du brevet:
**23.11.89 Bulletin 89/47**

(84) Etats contractants désignés:
**DE GB NL**

(56) Documents cités:
**EP-A- 0 101 960**
**GB-A- 1 495 186**

**IEEE TRANSACTIONS ON ELECTRON DEVICES, vol. ED-29, no. 10, octobre 1982, pages 1541-1547, IEEE, New York, US; N. YOKOYAMA et al.: "TiW silicide gate self-alignment technology for ultra-high-speed GaAs MESFET LSI/VLSI's"**
**IBM TECHNICAL DISCLOSURE BULLETIN, vol. 22, no. 8B, janvier 1980, pages 3861-3863, New York, US; V.L. RIDEOUT: "Fabrication method for high performance MESFET"**

(73) Titulaire: **THOMSON-CSF, 51, Esplanade du Général de Gaulle, F-92800 Puteaux(FR)**

(72) Inventeur: **Kohn, Erhard, THOMSON-CSF SCPI-19 avenue de Messine, F-75008 Paris(FR)**

(74) Mandataire: **Taboureau, James et al, THOMSON-CSF SCPI, F-92045 PARIS LA DEFENSE CEDEX 67(FR)**

## Description

La présente invention concerne un procédé de fabrication de transistor à effet de champ, à grille autoalignée en métal réfractaire, sur jonction de type P-N.

Ce procédé vise essentiellement à supprimer les inconvénients consécutifs aux procédés classiques de réalisation d'un transistor à effet de champ à grille autoalignée, en particulier en ce qui concerne la pollution de la couche active, sous la grille, par des atomes métalliques qui ont diffusé, ainsi qu'en ce qui concerne la tension de claquage entre grille et drain.

L'invention sera exposée en s'appuyant sur le cas d'un transistor à effet de champ en GaAs, parce que l'arseniure de gallium est actuellement le matériau le plus courant pour réaliser des transistors hyperfréquences, mais il est bien entendu qu'elle s'applique plus généralement à tous les matériaux semiconducteurs utilisés pour les transistors à effet de champ, en particulier ceux du groupe III-V et le silicium. Cette convention qui n'a d'autre objet que de simplifer le langage, ne limite pas la portée de l'invention, que l'homme de l'art peut aisément transposer dans d'autres matériaux.

Les transistors à effet de champ à grille autoalignée sont connus : ce sont des transistors dans lesquels un sillon est creusé, dans la couche active, entre les métallisations de source et de drain, les bords de celles-ci s'avançant en porte à faux au-dessus des bords du sillon. Cette géométrie résulte naturellement de l'opération de creusement du sillon, au cours de laquelle le matériau semiconducteur de la couche active est aussi attaqué latéralement. Ainsi, les bords des métallisations de source et de drain servent de masque au cours du dépôt, dans le fond du sillon, de la métallisation de grille, par pulvérisation de métaux sous forte puissance, ce qui la rend directionnelle : la grille est ainsi autoalignée par rapport aux métallisations de source et de drain. Mais ce procédé connu, qui est essentiellement appliqué aux transistors de type MESFET c'est-à-dire transistor à effet de champ métal-semiconducteur à grille Schottky, a l'inconvénient d'introduire des atomes métalliques, provenant de la grille Schottky, dans la couche active. Ces atomes, qui diffusent au cours des traitements de recuit que subit le transistor en cours de fabrication, polluent la couche active, agissant comme piège profond pour les porteus de charges.

Selon le procédé de l'invention, la surface de la couche active est d'abord protégégée par une couche de protection. Un masque de résine en double couche est déposé sur la couche de protection: selon une technique connue, un sillon est ouvert dans ce masque de résine, en laissant la couche extérieure former deux surplombs au-dessus du sillon. Puis une partie de la couche de protection, correspondant à l'ouverture dans la couche extérieure de résine, est supprimée par gravure réactive. La couche de protection forme donc un nouveau niveau de masquage, à travers lequel la couche active, d'un premier type de conductivité, subit une implantation qui la transforme localement, donnant un caisson de type de conductivité inversée par rapport à celle de la couche active. Il y a donc formation d'une jonction P-N. Une métallisation de grille réfractaire est alors déposée dans le fond du sillon: les atomes métalliques, provenant de la grille réfractaire, qui diffusent dans le caisson sont masqués par celui-ci, et la jonction P-N de grille reste propre, sans pollution ni piège profond. Le transistor est achevé en supprimant la double couche de résine et en réalisant les électrodes de source et de drain selon des techniques connues.

De façon plus précise l'invention concerne un procédé de réalisation d'un transistor à effet de champ à jonction (JFET), à métallisation de grille autoalignée, comportant, supportée par un substrat au moins une couche d'un matériau semiconducteur d'un premier type de conductivité, ce procédé étant caractérisé en ce qu'il comporte les étapes suivantes:

– dépôt sur la couche semiconductrice d'une couche de protection, minérale,

– dépôt sur la couche de protection d'une double couche de résines organiques, et ouverture dans cette double couche d'un sillon, la couche extérieure de résine formant surplomb au-dessus du sillon,

– élimination partielle de la couche de protection par gravure ionique, à travers le sillon, laissant une ouverture de dimensions égales à celles de l'ouverture du surplomb (21) et à celles de la future grille,

– implantation sous faible énergie, à travers l'ouverture de la couche de protection, d'atomes qui forment dans la couche semiconductrice un caisson dont la conductivité est de type opposée à celle de ladite couche, formant ainsi une jonction P-N, la profondeur de l'implantation étant supérieure à la longueur de diffusion d'atomes de métaux dans la couche semiconductrice (11),

– dépôt, par pulvérisation sous faible pression et faible puissance, de la métallisation réfractaire de grille, en forme de champignon s'appuyant sur la couche de protection,

– élimination de la double couche de résines,

– implantation, sous forte énergie, de deux caissons surdopés, dans la couche semiconductrice, en autoalignement par rapport à la métallisation de grille qui sert de masque,

– achèvement du transistor par l'élimination localisée de la couche de protection et dépôt sur les caissons surdopés de deux métallisations de source et drain.

L'invention sera mieux comprise par la description suivante d'un exemple de réalisation, cette description s'appuyant sur les figures en annexe qui représentent:

– figure 1: coupe d'un transistor à effet de champ à grille autoalignée selon l'art connu,

– figure 2: coupe d'un transistor à effet de champ à grille autoalignée selon l'invention,

– figures 3 à 6: différentes étapes du procédé de réalisation d'un transistor à effet de champ à grille autoalignée selon l'invention.

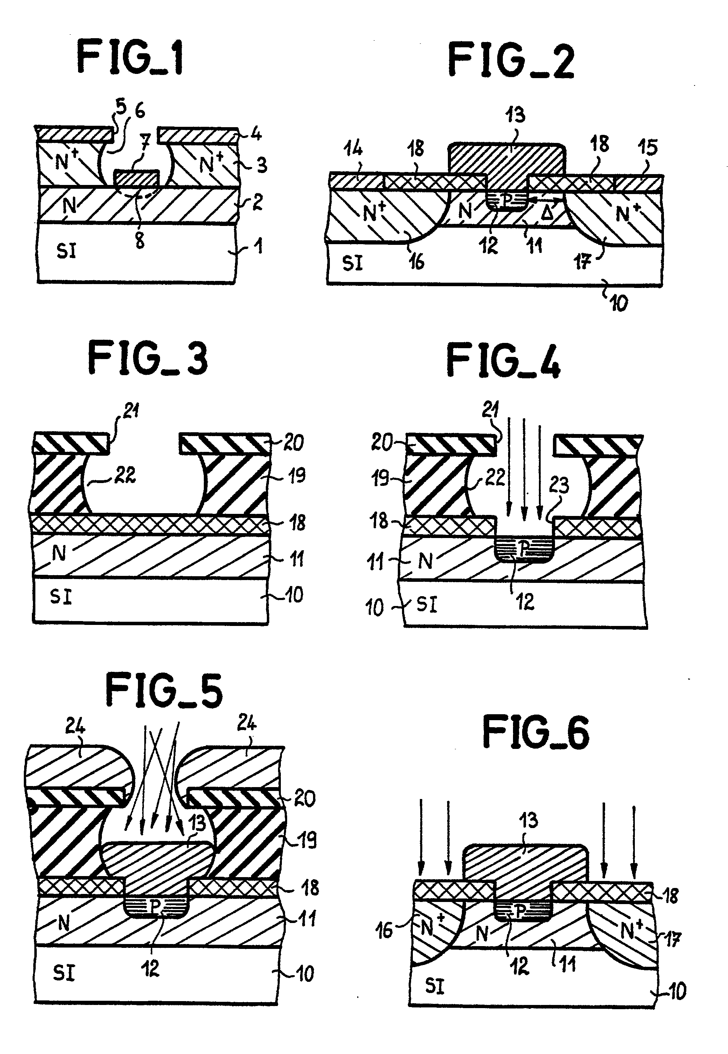

La figure 1 représente une vue en coupe d'un transistor à effet de champ à grille autoalignée selon l'art connu, et n'a d'autre objet que de montrer les inconvénients de cette structure.

Un transistor à effet de champ à grille autoalignée comporte, selon les configurations connues jusqu'à présent, un substrat 1 qui supporte une couche 2 dite active, d'un matériau tel que GaAs légèrement dopé de type N. Sur cette couche de type N on dépose une seconde couche 3 d'avantage dopée de type N⁺ de façon à prendre de meilleurs contacts avec les métallisations de source et de drain. Celles-ci appartiennent à une couche métallique 4, de type or-germanium, déposée sur la couche 3 de prise de contact.

Pour réaliser une grille autoalignée dans cette structure, la couche métallique 4 est convenablement masquée par une résine puis attaquée, de façon à y pratiquer une ouverture 5, dont la largeur correspond à la longueur de la grille que l'on veut réaliser. A travers l'ouverture 5, qui sépare désormais la métallisation 4 en une métallisation de source et une métallisation de drain, la couche 3 de matériau semiconducteur est attaquée, ce qui crée un sillon 6, dont la largeur est d'ailleurs supérieure à la largeur de l'ouverture 5 parce que le matériau semiconducteur est aussi attaqué latéralement, pendant que le sillon se creuse. Lorsque le sillon 6 atteint la couche 2 dite active, l'attaque est arrêtée et une électrode de grille 7 et déposée par pulvérisation sous haute énergie de métaux Schottky.

Ce procédé classique de réalisation d'un MESFET à grille Schottky a cependant des inconvénients.

Le premier est que la tension de polarisation de grille en direct est limitée à environ 0,8 volts, correspondant à la hauteur de barrière moyenne entre un métal à contact Schottky et un matériau semiconducteur tel que GaAs.

Le second inconvénient est que, en dessous de la métallisation de grille 7, existe une région 8 plus ou moins bien définie dans laquelle des atomes de titane, de fer ou de chrome par exemple provenant de la métallisation Schottky, selon la nature du métal utilisé bien entendu, polluent la couche active. Les atomes métalliques qui ont diffusé dans cette région 8 ont pu le faire en raison des opérations de recuit qui ont toujours lieu au cours de la fabrication d'un transistor, et ces atomes se manifestent comme des pièges profonds pour les porteurs de charge. Par conséquent le fonctionnement normal de la couche active est perturbé par ces atomes pièges profonds.

Enfin le potentiel de claquage entre l'électrode de grille et l'électrode de drain est faible, car il n'y a aucune séparation ou quasiment aucune séparation entre la métallisation de grille 7 et la couche semiconductrice 3. Une séparation peut être créée en augmentant, sous le surplomb des métallisations de source et de drain, la largeur du sillon 6, de façon à amener une séparation entre la métallisation de grille 7 et la couche 3, mais cette séparation représente une résistance série, non linéaire, avec une important saturation en courant, ce qui détériore les qualités du transistor à effet de champ.

Le procédé de réalisation d'un transistor à effet de champ selon l'invention améliore les trois points décrits ci-dessus, et permet de réaliser un transistor pour lequel on conservera l'appellation d'autoaligné, bien que cela ne soit pas évident sur la figure 2, qui représente un transistor conforme au procédé de l'invention. La dénomination d'autoaligné reste due au procédé de réalisation.

De façon à mieux comprendre le procédé de réalisation selon l'invention, on commencera par considérer en figure 2 le transistor tel qu'il est réalisé, à la fin de ce processus de fabrication.

Celui-ci comporte un substrat 10 en arseniure de gallium, ou autres matériaux semiconducteurs, très résistif ou semi-isolant. Sur ce substrat est déposée ou implantée une couche active 11, par exemple en GaAs de type N et, inclus dans cette couche 11, un caisson 12 en GaAs de conductivité de type P. Sur le caisson 12, et autoaligné sur ses bords par un procédé qui sera détaillé ultérieurement, une métallisation 13 de grille, en métal ou alliage de métaux réfractaires. Le transistor est complété par deux électrodes de source et de drain, 14 et 15, en métaux tel que or-germanium, ces deux électrodes s'appuyant sur des caissons 16 et 17, de type N⁺ si la couche 11 est de type N, ces caissons étant implantés dans la couche 11 et partiellement dans le substrat 10. Enfin une couche superficielle isolante 18 entoure à sa base la métallisation de grille 13 qui est en forme de champignon, et la sépare des métallisations de source et de drain 14 et 15.

Un tel transistor à effet de champ est réalisé selon le procédé illustré par les figures 3 à 6.

A l'origine, le procédé part d'un substrat par exemple de GaAs semi-isolant. Une couche 11 de type N est déposée sur ou implantée dans ce substrat. Cette structure de base est d'abord recouverte par une couche minérale de protection 18 de faible épaisseur, de l'ordre de 50 nm, en nitrure de silicium $Si_3N_4$ ou en silice $SiO_2$ par exemple. L'objet de cette couche minérale 18 est de garder propre la surface de la couche implantée 11 durant toute la suite des opérations. Puis l'ensemble est recouvert par une double couche de résine, une première couche intérieure 19 et une couche extérieure 20, choisie de telle façon que la couche 19 est plus facilement attaquée ou dissoute que la couche 20. Par un procédé connu, on ouvre une ouverture 21 dans la couche extérieure 20 puis on poursuit l'attaque ou la dissolution de la couche de résine 19 de façon a obtenir un sillon 22, dont la largeur est supérieure à l'ouverture 21 de telle sorte que la couche de résine extérieure 20 forme deux surplombs au-dessus du sillon 22. La largeur de l'ouverture 21 est sensiblement égale à la longueur de la grille à réaliser.

La seconde étape est représentée en figure 4. Elle consiste à d'abord pratiquer une ouverture 23 dans la couche de protection 18, par gravure ionique qui est directionnelle. En raison de la présence de l'ouverture 21 dans la couche de résine extérieure 20, l'ouverture 23 dans la couche de protection 18 correspond à l'ouverture 21 et a la même largeur qu'elle. Ensuite, la couche de protection 18 étant localement supprimée en 23, la couche de matériau semiconducteur 11 qui est dégagée en cet endroit est implantée, sous faible énergie, par exemple par des atomes de beryllium $-10^{13}$ $-10^{14}$ ions.cm$^{-2}$ de Be$^+$ de façon à créer un petit caisson 12 de conductivité de type P, qui forme donc une jonction P–N avec la couche active 11. Le transistor à effet de champ réalisé par le procédé de l'invention sera donc un transistor à jonction P–N, et non pas un transistor de type MESFET à grille Schottky. La profondeur de l'implantation, soit celle du caisson 12, est supérieure à la longueur de diffusion d'atomes de métaux dans la couche semiconductrice 11.

Dans l'étape suivante, représentée en figure 5, l'électrode de grille 13 est déposée par pulvérisation à faible puissance. Celle-ci n'est pas directionnelle, et les flèches symbolisent que les atoms métalliques se propagent un peu dans toutes les directions, et remplissent sur une certaine hauteur le sillon 22 creusé dans la couche de résine 19. En remplissant partiellement le sillon 22, l'électrode de grille 13 prend une forme dite de champignon, et s'appuie latéralement, sur environ 0,2–0,3 microns, sur la couche de protection 18. Les métaux pulvérisés sont des métaux réfractaires ou des alliages, de type WSi ou TiWSi: il est nécessaire qu'ils soient réfractaires en raison des opérations de recuit qui ont toujours lieu dans la fabrication des transistors. Bien entendu au cours de cette opération de métallisation de la grille du transistor, une couche équivalente 24 de métal réfractaire se dépose sur la surface de la résine extérieure 20, mais cela est sans importance parce que cette couche ainsi que les résines seront supprimées dans l'opération suivante.

C'est dans cet état qu'est représenté le transistor, figure 6, après dissolution des résines 19 et 20, ce qui a automatiquement entraîné la séparation de la pellicule métallique 24. Deux caissons 16 et 17, de type N$^+$, destinés aux contacts de source et de drain sont alors réalisés par une implantation de silicium à haute dose, c'est-à-dire de l'ordre de $10^{13}$ at.cm$^{-2}$. Cette implantation peut se faire à travers la couche de protection 18 car celle-ci n'a qu'une épaisseur de l'ordre de 50nm.

Pour achever le transistor, tel qu'il est représenté en figure 2 il suffit alors de décaper localement la couche de protection 18 de façon à atteindre les caissons 16 et 17: en ces endroits peuvent être déposées deux métallisations 14 et 15 de source et de drain, celles-ci étant par exemple réalisées en orgermanium.

A titre indicatif et sans pour autant introduire une limitation à la portée de l'invention, le caisson 12 sous la métallisation de grille 13 est implanté sur une épaisseur de l'ordre de 50 nm. Sa largeur, qui correspond à la longueur de la grille, c'est-à-dire à la distance mesurée dans le sens du courant allant de la source vers le drain, est inférieure à  micron, ce qui est dans les ordres de grandeur des transistors hyperfréquences ou logiques rapides sur arseniure de gallium. D'un autre côté la distance repérée Δ en figure 2, c'est-à-dire la longueur de la couche de protection 18 sur laquelle s'appuie le champignon, qui sépare le caisson 12 de grille du caisson 17 de drain est de l'ordre de 0,2 à 0,3 micron. Ceci est suffisant pour augmenter le potentiel de claquage et séparer les régions de grille et de drain. Cette distance est obtenue en raison du procédé de fabrication qui fait que le sillon 22 dans la résine 19 est plus large que l'ouverture 21 dans la résine 20, et que par pulvérisation à faible puissance la métallisation 13 de grille n'est pas une métallisation autoalignée dans le sens où la métallisation de grille 7 était autoalignée dans la figure 1 de l'art connu. Au contraire cette métallisation 13 de grille a une forme de champignon et l'autoalignement des caissons 16 et 17 sur les bords de la grille 13 permet d'obtenir automatiquement cette distance Δ qui augmente le potentiel de claquage entre source et drain.

Il convient d'observer que, dans l'art connu, la grille était réalisée en dernier, autoalignée sur la source et le drain, tandis que selon l'invention, la grille est réalisée en premier, et la source et le drain sont autoalignés sur elle.

Les inconvénients de l'art connu tels qu'ils ont été cités au début de ce texte sont en partie supprimés par le procédé de l'invention. En premier lieu, la tension maximale de polarisation de la grille peut atteindre 1,4 volts comme dans les transistors à effet de champ à jonction, puisqu'en fait le transistor n'est plus un transistor Schottky mais un JFET. Ensuite la région polluée par des atomes diffusés, sous la métallisation de grille, est masquée par le caisson 12 qui est de niveau de dopage controlé et qui crée une jonction P-N, la seule à jouer un rôle dans le fonctionnement du transistor. Enfin, la zone de séparation entre grille et contact, repérée Δ en figure 2, a une profondeur plus large que celle du canal au-dessus du contact de grille, ce qui améliore le potentiel de claquage entre grille et drain.

Bien entendu un transistor à effet de champ à grille autoalignée peut être réalisé comme cela a été dit précédemment avec d'autre matériaux que GaAs, mais également les types de conductivités peuvent être inversés par rapport à ce qui a été décrit, et même la structure profonde du transistor peut être totalement différente. Le procédé de l'invention est ainsi applicable à n'importe quel type de transistor qui comporterait plusieurs couches autres que la couche active, en particulier des couches de lissage, ou des hétérojonctions entre matériaux de types différents. Le point principal du procédé de l'invention est de masquer les atomes diffusés au cours des opérations de recuit d'une grille réfractaire, au moyen d'un petit caisson, juste sous la métallisation de grille, ce caisson formant une jonction P-N qui masque l'effet des pièges profonds.

Ce type de transistor est préférentiellement utilisé dans les circuits intégrés hyperfréquences, en particulier, les circuits logiques rapides sur arseniure de gallium, qui sont destinés à tous les matériels utilisant des micro-ondes tels que les systèmes de télécommunication ou de faisceaux hertziens ou radars par exemple.

**Revendications**

1. Procédé de réalisation d'un transistor à effet de champ à jonction (JFET), à métallisation de grille autoalignée, comportant, supportée par un substrat (10), au moins une couche (11) d'un matériau semiconducteur d'un premier type de conductivité, ce procédé étant caractérisé en ce qu'il comporte les étapes suivantes:

— dépôt sur la couche semiconductrice (11) d'une couche (18) de protection, minérale,

— dépôt sur la couche de protection (18) d'une double couche (19, 20) de résines organiques, et ouverture dans cette double couche (19, 20) d'un sillon (22), la couche extérieure de résine (20) formant surplomb (21) au-dessus du sillon (22),

— élimination partielle de la couche de protection (18) par gravure ionique, à travers le sillon (22), laissant une ouverture (23) de dimensions égales à celles de l'ouverture du surplomb (21) et à celles de la future grille,

— implantation sous faible énergie, à travers l'ouverture (23) de la couche de protection (18), d'atomes qui forment dans la couche semiconductrice (11) un caisson (12) dont la conductivité est de type opposé à celle de ladite couche (11), formant ainsi une jonction P–N, la profondeur de l'implantation étant supérieure à la longueur de diffusion d'atomes de métaux dans la couche semiconductrice (11),

— dépôt, par pulvérisation sous faible pression et faible puissance, de la métallisation réfractaire de grille (13), en forme de champignon s'appuyant sur la couche de protection (18),

— élimination de la double couche de résines (19, 20),

— implantation, sous forte énergie, de deux caissons (16, 17) surdopés, dans la couche semiconductrice (11), en autoalignement par rapport à la métallisation de grille (13) qui sert de masque,

— achèvement du transistor par l'élimination localisée de la couche de protection (18) et dépôt sur les caissons surdopés (16, 17) de deux métallisations de source et drain (14, 15).

2. Procédé de réalisation d'un transistor selon la revendication 1, caractérisé en ce que la métallisation de grille (13) est réalisée au moyen de métaux réfractaires, tels que WSi ou TiWSi.

3. Procédé de réalisation d'un transistor selon la revendication 1, caractérisé en ce que la couche de protection (18) est une couche de nitrure ou d'oxyde de silicium $Si_3N_4$ ou $SiO_2$.

4. Procédé de réalisation d'un transistor selon la revendication 1, caractérisé en ce que le substrat (10) et au moins une couche active (11) sont en matériaux semiconducteurs du groupe III–V tel que GaAs.

**Claims**

1. A method for the production of a junction field effect transistor (JFET) with an autoaligned metallized gate, comprising, supported on a substrate (10), at least one layer (11) of a semiconductor material of a first type of conductivity, said method being characterized in that it comprises the following steps:

— the deposit on the semiconductor layer (11) of a mineral protective layer (18),

— the deposit on the protective layer (18) of a double layer (19 and 20) of organic resins, and the provision in this double layer (19 and 20) of a groove (22), the outer layerce of the resin (20) running cantileverwise (21) over the groove (22),

— the partial elimination of the protective coating (18) by ionic etching, through the groove (22) so as to leave an opening (23) with dimensions equal to these of the opening of the cantilever (21) and to those of the future gate,

— low energy implantation, through the opening (23) in the protective layer (18), of atoms which form a pit (12) in the semiconductor layer (11), the conductivity of the pit (12) being opposite that of the said layer (11) so as to form a PN junction, the depth of implantation being greater than the diffusion path of metal atoms in the semiconductor layer (11),

— low pressure and low power sputter deposition of the refractory metallized gate layer (13) in the form of a mushroom resting on the protective layer (18),

— elimination of the double resin layer (19 and 20),

— high energy implantation of two overdoped pits (16 and 17) in the semiconductor layer (11) with a self-alignment with respect to the gate metallized layer (13), which serves as a mask, and

— completion of the transistor by the local elimination of the protective layer (18) and the deposit of two source and drain metallized layers (14 and 15) on the overdoped pits (16 and 17).

2. The method of producing a transistor as claimed in claim 1, characterized in that the gate metallized layer (13) is produced using two refractory metals such as WSi or TiWSi.

3. The method of producing a transistor as claimed in claim 1, characterized in that the protective layer (18) is a layer of silicon nitride $Si_3N_4$ or of silicon oxide $SiO_2$.

4. The method of producing a transistor as claimed in claim 1, characterized in that the substrate (10) and at least one active layer (11) are made of semiconductor materials of the III–V group such as GaAs.

**Patentansprüche**

1. Verfahren zur Herstellung eines Grenzschicht-Feldeffekt-Transistors (JFET), mit selbstausrichtender Gate-Metallisierung, umfassend — getragen durch ein Substrat (10) — mindestens eine Schicht (11) eines Halbleiterstoffes einer ersten Leitfähigkeitsart, wobei dieses Verfahren dadurch gekennzeichnet ist, daß es die folgenden Stufen umfaßt:

— Auftragung einer mineralischen Schutzschicht (18) auf der Halbleiterschicht (11),

— Auftragung einer Doppelschicht (19, 20) von organischen Harzen auf der Schutzschicht (18) und Eröffnung einer Rille (22) in dieser Doppelschicht, wobei die äußere Harzschicht (20) über die Rille (22) hinausragt (21),

— teilweise Beseitigung der Schutzschicht (18) mittels Ionengravierung durch die Rille (22) hindurch, wobei eine Öffnung (23) gleicher Abmessungen wie diejenigen der Öffnungen des überragenden Teils (21) und diejenigen des künftigen Gate übriggelassen wird,

– Schwachenergie-Implantation, durch die Öffnung (23) der Schutzschicht (18) hindurch, von Atomen, die in der Halbleiterschicht (11) eine Kammer (12) bilden, deren Leitfähigkeit von der entgegengesetzten Art derjenigen besagter Schicht (11) ist, wodurch solcherart ein P-N-Übergang gebildet wird, wobei die Implantationstiefe größer als die Diffusionslänge von Metallatomen in der Halbleiterschicht (11) ist,

– Durch Zerstäubung unter schwachem Druck und schwacher Leistung erfolgendes Auftragen der feuerfesten Gate-Metallisierung (13) in einer sich auf die Schutzschicht (18) stützenden Pilzform,

– Beseitigung der Doppelschicht von Harzen (19, 20),

– Hochenergie-Implantation von zwei übergedopten Kammern (16, 17) in der Halbleiterschicht (11), in Selbstausrichtung gegenüber der als Maske dienenden Gate-Metallisierung (13),

– Fertigstellung des Transistors durch örtlich begrenzte Beseitigung der Schutzschicht (18) und Auftragung von zwei Source- und Drain-Metallisierungen (14, 15) auf den übergedopten Kammern (16, 17).

2. Verfahren zur Herstellung eines Transistors nach Anspruch 1, dadurch gekennzeichnet, daß die Gate-Metallisierung (13) mittels feuerfesten Metallen wie WSi oder TiWSi durchgeführt wird.

3. Verfahren zur Durchführung eines Transistors nach Anspruch 1, dadurch gekennzeichnet, daß die Schutzschicht (18) eine Schicht aus Siliziumnitrid oder Siliziumoxid, $Si_3N_4$ oder $SiO_2$ ist.

4. Verfahren zur Durchführung eines Transistors nach Anspruch 1, dadurch gekennzeichnet, daß das Substrat (10) und mindestens eine Aktivschicht (11) aus Halbleiterstoffen der Gruppe III–V sind, wie z.B. GaAs.

FIG_1

FIG_2

FIG_3

FIG_4

FIG_5

FIG_6